# EUROPEAN PATENT APPLICATION

(11) **EP 2 465 966 A1**
(43) Date of publication of application: **20.06.2012**
(21) Application number: 10195149.9
(22) Date of filing: 15.12.2010
(51) Int. Cl.: C23C 14/06, C23C 14/22, G06F 3/047, G06F 3/046, G06F 3/045, H01L 31/18

(54) **Transparent conductive structure and method of making the same**

(71) Applicant: Innovation & Infinity Global Corp., Hsinchu City (TW)
(72) Inventor: Chu, Chao-Chieh, 300, Hsinchu City (TW)
(74) Representative: Viering, Jentschura & Partner

(57) **Abstract**

A transparent conductive structure includes a substrate unit (1) and a conductive unit (2). The substrate unit (1) includes at least one plastic substrate (10). The conductive unit (2) includes at least one transparent conductive film (20) and at least one nanometer conductive group (21) formed at the same time, wherein the transparent conductive film is formed on the plastic substrate, and the nanometer conductive group includes a plurality of conductive nanowire filaments (210) mixed or embedded in the transparent conductive film (20). In other words, both the transparent conductive film and the nanometer conductive group in the instant disclosure can be respectively formed by two different forming methods (such as sputtering and vaporing) at the same time, and the conductive nanowire filaments of the nanometer conductive group can be formed inside the transparent conductive film.

## Description

### BACKGROUND OF THE INVENTION

### 1. Field of the Invention

The instant disclosure relates to a transparent conductive structure and a method of making the same, and more particularly, to a transparent conductive structure having nano-scale conductive mixtures and a method of making the same.

### 2. Description of Related Art

In 1970, touch panel is originated for military usage in United States of America. Until 1980, technologies related to touch panel were published and utilized to be other applications. Now, touch panel is universal and applied to replace input device like keyboard or mouse. Especially, most of electrical equipments such as Automatic Teller Machine (ATM), Kiosks, Point of Service (POS), household appliances, industrial electronics and so on are equipped with touch panel and its technologies to make input easily. In addition, more and more the consumer products take this trend to make them thin, light, short and small to carry, for example, personal digital assistant (PDA), mobile phone, notebook, laptop, MP3 player and so on.

Generally speaking, there are two kinds of touch panel. One is resistive touch panel, and another is capacitive touch panel. Resistive touch panel is a mainstream in the market because of low cost. Resistive touch panels have a flexible top layer and a rigid bottom layer separated by insulating dots, with the inside surface of each layer coated with a transparent metal oxide. Material of the top layer and the bottom layer is polyethylene terephthalate (PET), while material of the inside surface of each layer is indium tin oxide (ITO). The resistive panel is placed on the liquid crystal display or the graphic device and being pressed by an object like a finger to make a touch point, the coordinate of the touch point is record in the touch screen device.

On the other hand, a capacitive touch screen panel is coated with a material, typically indium tin oxide or antinomy tin oxide that conducts a continuous electrical current across the sensor. The sensor therefore exhibits a precisely controlled field of stored electrons in both the horizontal and vertical axes (it achieves capacitance). The human body is also an electrical device which has stored electrons and therefore also exhibits capacitance. When the sensor's normal capacitance field (its reference state) is altered by another capacitance field, i.e., someone's finger, electronic circuits located at each corner of the panel measure the resultant distortion in the sine wave characteristics of the reference field and send the information about the event to the controller for mathematical processing. Capacitive sensors can either be touched with a bare finger or with a conductive device being held by a bare hand. Capacitive touch screens are not affected by outside elements and have high clarity, but their complex signal processing electronics increase their cost.

The resistive touch panel is economic for end user but it has a response time lower than the capacitive touch panel which could be applied to be a special input interface, like a gesture input.

### SUMMARY OF THE INVENTION

One particular aspect of the instant disclosure is to provide a transparent conductive structure having nano-scale conductive mixtures and a method of making thereof.

To achieve the above-mentioned advantages, one embodiment of the instant disclosure provides a transparent conductive structure, comprising: a substrate unit and a conductive unit. The substrate unit includes at least one plastic substrate. The conductive unit includes at least one transparent conductive film and at least one nanometer conductive group formed at the same time, wherein the transparent conductive film is formed on the plastic substrate, and the nanometer conductive group includes a plurality of conductive nanowire filaments mixed or embedded in the transparent conductive film.

To achieve the above-mentioned advantages, one embodiment of the instant disclosure provides a method of making a transparent conductive structure, comprising the steps of: providing at least one plastic substrate; placing the plastic substrate into a chamber; and respectively forming at least one transparent conductive film and at least one nanometer conductive group by a first forming method and a second forming method at the same time, wherein the transparent conductive film is formed on the plastic substrate, and the nanometer conductive group includes a plurality of conductive nanowire filaments mixed or embedded in the transparent conductive film.

Therefore, both the transparent conductive film and the nanometer conductive group in the instant disclosure can be respectively formed by two different forming methods (such as sputtering and vaporing) at the same time, and the conductive nanowire filaments of the nanometer conductive group can be formed inside the transparent conductive film.

To further understand the techniques, means and effects the instant disclosure takes for achieving the prescribed objectives, the following detailed descriptions and appended drawings are hereby referred, such that, through which, the purposes, features and aspects of the instant disclosure can be thoroughly and concretely appreciated. However, the appended drawings are provided solely for reference and illustration, without any intention that they be used for limiting the instant disclosure.

### BRIEF DESCRIPTION OF THE DRAWINGS

FIG. 1 shows a flowchart of the method of making the transparent conductive structure according to the instant disclosure;

FIG. 2 shows a perspective, schematic view of forming the transparent conductive structure in the chamber according to the instant disclosure; and

FIG. 3 shows a lateral, schematic view of the transparent conductive structure according to the instant disclosure.

### DETAILED DESCRIPTION OF THE PREFERRED EMBODIMENTS

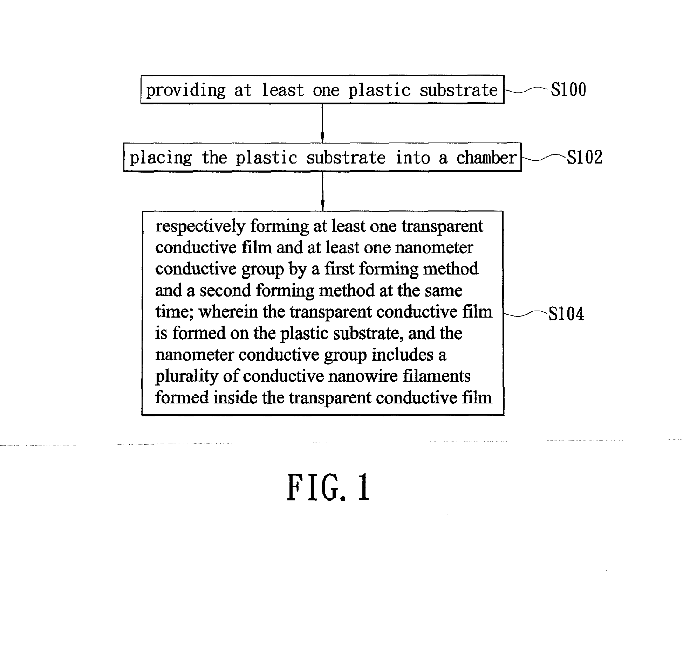

Referring to FIGS. 1 to 3, the instant disclosure provides a method of making a transparent conductive structure Z having nano-scale conductive mixtures, including the steps of:

The step S 100 is that: first, providing at least one plastic substrate 10. For example, the plastic substrate 10 may be made of PET (polyethylene Terephthalate), PC (Poly Carbonate), PE (polyethylene), PVC (Poly Vinyl Chloride), PP (Poly Propylene), PS (Poly Styrene) or PMMA (Polymethylmethacrylate) according to different requirements.

The step S 102 is that: next, placing the plastic substrate 10 into a chamber C. For example, the chamber C may be a vacuum chamber.

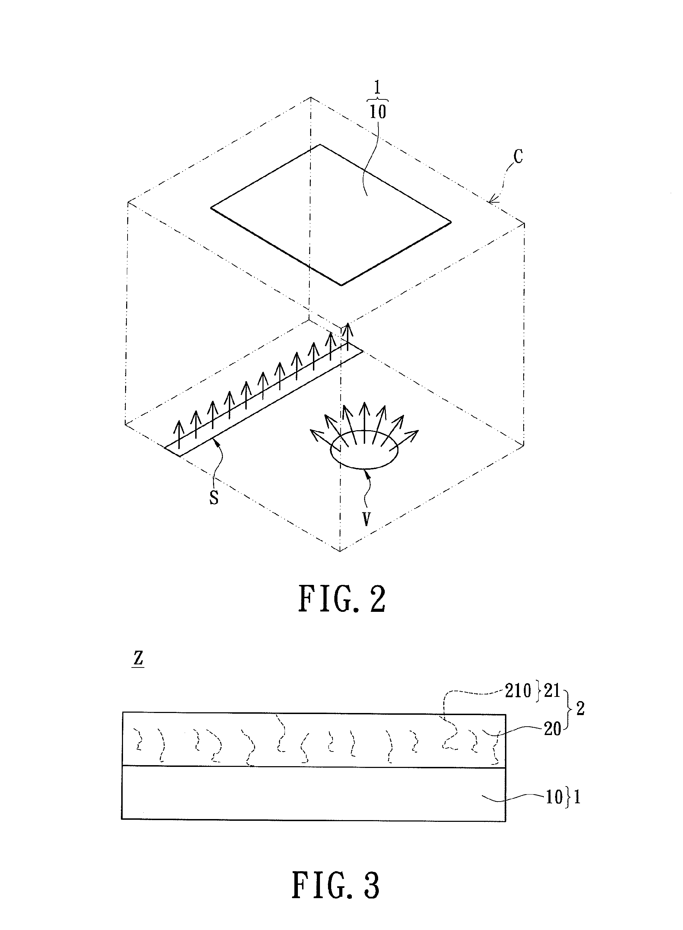

The step S104 is that: finally, respectively forming at least one transparent conductive film 20 and at least one nanometer conductive group 21 by a first forming method and a second forming method at the same time (it means both the transparent conductive film 20 and the nanometer conductive group 21 are formed simultaneously); wherein the transparent conductive film 20 is formed on the plastic substrate 10, and the nanometer conductive group 21 includes a plurality of conductive nanowire filaments 210 mixed or embedded in the transparent conductive film 20 (as shown in FIG. 3). For example, the transparent conductive film 20 may be an ITO (Indium Tin Oxide), and the thickness of the transparent conducive film 20 may be between 150Å and 300Å according to different requirements. In addition, each conductive nanowire filament 210 may be a gold nanowire filament, a silver nanowire filament, a copper nanowire filament, or any type of nanowire filament having nanometer wire diameter and conductive function etc. and the wire diameter of each conductive nanowire filament 210 may be between 1 nm and 10 nm according to different requirements.

For example, in the step S104, the first forming method may be sputter deposition S and the second forming method may be vapor deposition V, thus the transparent conductive film 20 and the nanometer conductive group 21 can be respectively formed by sputtering and vaporing at the same time. In other words, when the transparent conductive film 20 is formed gradually on the plastic substrate 10 by sputtering, the conductive nanowire filaments 210 are also formed gradually in the transparent conductive film 20 by vaporing at the same time. Hence, when the transparent conductive film 20 is formed to achieve a predetermined thickness by sputtering, the conductive nanowire filaments 210 are also uniformly formed inside the transparent conductive film 20. In addition, because the transparent conductive film 20 and the conductive nanowire filaments 210 are formed simultaneously, the instant disclosure can reduce a manufacturing process. Moreover, because the conductive nanowire filaments 210 are formed in the transparent conductive film 20, the thickness of the transparent conductive structure Z can be reduced. Hence, when the transparent conductive structure Z is applied to a capacitance touch panel (such as the size of panel larger than 5 inch), the reaction sensitivity of the capacitance touch panel is increased for user to control or operate the capacitance touch panel with the transparent conductive structure Z easily.

Therefore, referring to FIG. 3, the instant disclosure provides a transparent conductive structure Z having nano-scale conductive mixtures, including a substrate unit 1 and a conductive unit 2.

The substrate unit 1 includes at least one plastic substrate 10. For example, the plastic substrate 10 may be made of PET, PC, PE, PVC, PP, PS or PMMA material according to different requirements.

The conductive unit 2 includes at least one transparent conductive film 20 and at least one nanometer conductive group 21 formed at the same time (it means both the transparent conductive film 20 and the nanometer conductive group 21 are formed simultaneously). The transparent conductive film 20 is formed on the plastic substrate 10, and the nanometer conductive group 21 includes a plurality of conductive nanowire filaments 210 mixed or embedded in the transparent conductive film 20. For example, the transparent conductive film 20 may be an ITO (Indium Tin Oxide), and the thickness of the transparent conducive film 20 may be between 150Å and 300Å according to different requirements. In addition, each conductive nanowire filament 210 may be a gold nanowire filament, a silver nanowire filament, a copper nanowire filament, or any type of nanowire filament having nanometer wire diameter and conductive function etc. and the wire diameter of each conductive nanowire filament 210 may be between 1 nm and 10 nm according to different requirements.

For example, the transparent conductive film 20 and the nanometer conductive group 21 can be respectively formed by sputtering and vaporing at the same time. In other words, when the transparent conductive film 20 is formed gradually on the plastic substrate 10 by sputtering, the conductive nanowire filaments 210 are also formed gradually in the transparent conductive film 20 by vaporing at the same time. Hence, when the transparent conductive film 20 is formed to achieve a predetermined thickness by sputtering, the conductive nanowire filaments 210 are also uniformly formed inside the transparent conductive film 20. In addition, because the transparent conductive film 20 and the conductive nanowire filaments 210 are formed simultaneously, the instant disclosure can reduce a manufacturing process. Moreover, because the conductive nanowire filaments 210 are formed in the transparent conductive film 20, the thickness of the transparent conductive structure Z can be reduced. Hence, when the transparent conductive structure Z is applied to a capacitance touch panel (such as the size of panel larger than 5 inch), the reaction sensitivity of the capacitance touch panel is increased for user to control or operate the capacitance touch panel with the transparent conductive structure Z easily.

In conclusion, both at least one transparent conductive film and at least one nanometer conductive group can be respectively formed by two different forming methods (such as sputtering and vaporing) at the same time, and the nanometer conductive group includes a plurality of conductive nanowire filaments formed inside the transparent conductive film. In other words, because the transparent conductive film and the conductive nanowire filaments are formed simultaneously, the instant disclosure can reduce a manufacturing process. Moreover, because the conductive nanowire filaments are formed in the transparent conductive film, the thickness of the transparent conductive structure can be reduced. Hence, when the transparent conductive structure is applied to a capacitance touch panel (such as the size of panel larger than 5 inch), the reaction sensitivity of the capacitance touch panel is increased for user to control or operate the capacitance touch panel easily. Moreover, the instant disclosure has some advantages, such as good weather resistance, low resistance of 3 Ohm/square (3Ω/□), low color shift approaching zero (low b*≒0), and high transmittance (T≥90%) etc.

The above-mentioned descriptions merely represent the preferred embodiments of the instant disclosure, without any intention or ability to limit the scope of the instant disclosure which is fully described only within the following claims. Various equivalent changes, alterations or modifications based on the claims of instant disclosure are all, consequently, viewed as being embraced by the scope of the instant disclosure.

## Claims

1. A transparent conductive structure, comprising:
a substrate unit including at least one plastic substrate; and
a conductive unit including at least one transparent conductive film and at least one nanometer conductive group formed at the same time, wherein the transparent conductive film is formed on the plastic substrate, and the nanometer conductive group includes a plurality of conductive nanowire filaments mixed or embedded in the transparent conductive film.

2. The transparent conductive structure of claim 1, wherein the plastic substrate is one of PET (polyethylene Terephthalate), PC (Poly Carbonate), PE (polyethylene), PVC (Poly Vinyl Chloride), PP (Poly Propylene), PS (Poly Styrene) and PMMA (Polymethylmethacrylate) materials.

3. The transparent conductive structure of claim 1, wherein the transparent conductive film is an ITO (Indium Tin Oxide).

4. The transparent conductive structure of claim 1, wherein the transparent conducive film has a thickness of between 150Å and 300Å.

5. The transparent conductive structure of claim 1, wherein each conductive nanowire filament is a gold nanowire filament, a silver nanowire filament or a copper nanowire filament.

6. The transparent conductive structure of claim 1, wherein each conductive nanowire filament has a wire diameter of between 1 nm and 10 nm.

7. The transparent conductive structure of claim 1, wherein the transparent conductive film and the nanometer conductive group are respectively formed by sputtering and vaporing at the same time.

8. A method of making a transparent conductive structure, comprising the steps of:
providing at least one plastic substrate;
placing the plastic substrate into a chamber; and
respectively forming at least one transparent conductive film and at least one nanometer conductive group by a first forming method and a second forming method at the same time, wherein the transparent conductive film is formed on the plastic substrate, and the nanometer conductive group includes a plurality of conductive nanowire filaments mixed or embedded in the transparent conductive film.

9. The method of claim 8, wherein the plastic substrate is made of PET, PC, PE, PVC, PP, PS or PMMA.

10. The method of claim 8, wherein the transparent conductive film is an ITO.

11. The method of claim 8, wherein the transparent conducive film has a thickness of between 150Å and 300Å.

12. The method of claim 8, wherein each conductive nanowire filament is a gold nanowire filament, a silver nanowire filament or a copper nanowire filament.

13. The method of claim 8, wherein each conductive nanowire filament has a wire diameter of between 1 nm and 10 nm.

14. The method of claim 8, wherein the first forming method is sputter deposition and the second forming method is vapor deposition.
